# EUROPEAN PATENT APPLICATION

(11) **EP 1 895 020 A1**
(43) Date of publication of application: **05.03.2008**
(21) Application number: 06729897.6
(22) Date of filing: 24.03.2006
(51) Int. Cl.: C23C 14/00

(54) **SPUTTERING TARGET AND THIN FILM FOR OPTICAL INFORMATION RECORDING MEDIUM**

(30) Priority: 23.06.2005 JP 2005182788
(71) Applicant: Nippon Mining & Metals Co., Ltd., Minato-ku Tokyo 105-0001 (JP)
(72) Inventor: TAKAMI, Hideo ,Nikko Materials Co., Ltd., Kitaibaraki-shi, Ibaraki 3191535 (JP); YAHAGI, Masataka I,Nikko Materials Co.,Ltd., Kitaibaraki-shi, Ibaraki 3191535 (JP)
(74) Representative: Hoarton, Lloyd Douglas Charles
(86) International application number: PCT/JP2006/305949
(87) International publication number: WO 2006/137199

(57) **Abstract**

Provided is a sputtering target having zinc sulfide and indium oxide, zinc oxide and oxide composed of another trivalent positive element A as its primary components, wherein the ratio of sulfur in relation to the total components is 5 to 30wt%, the (111) peak strength I1 of cubic crystal ZnS and the (100) peak strength 12 of hexagonal ZnS measured by XRD coexist, and I1 > I12 is satisfied. The present invention aims to provide a high-strength sputtering target capable of preventing cracks in a target upon manufacturing such a target or when forming a film via sputtering and a manufacturing method of such a sputtering target, as well as a thin film for an optical information recording medium optimal for use as a protective film and a manufacturing method of such a thin film.

## Description

### TECHNICAL FIELD

The present invention relates to a sputtering target and a thin film (in particular for use as a protective film) for an optical information recording medium yielding amorphous stability in a thin film for an optical information recording medium protective layer, capable of DC sputtering upon forming a film via sputtering, capable of reducing arcings during sputtering and the generation of particles (dust) and nodules resulting from such arcings, having high density and limited variation in quality, and capable of improving the mass productivity.

### BACKGROUND ART

In recent years, high-density recording optical disc technology, which is rewritable high-density optical information recording medium without requiring a magnetic head has been developed, and is rapidly attracting attention. This optical disc can be classified into the three categories of ROM (read-only), R (write-once), and RW (rewritable). Particularly, the phase change method employed in the RW (RAM) type discs is attracting attention. The fundamental principle of the recording/reproduction employing this phase change optical disc is briefly described below,

This phase change optical disc performs the recording/reproduction of information by heating and increasing the temperature of a recording thin film on a substrate by irradiating a laser beam thereto, and generating a crystallographic phase change (amorphous ⇔ crystal) in the structure of such recording thin film. More specifically, the reproduction of information is conducted by detecting the change in the reflectivity caused by the change in the optical constant between the phases.

The aforementioned phase change is performed with the irradiation of a laser beam narrowed down to a diameter of approximately several hundred nm to several *µ*m. Here, for example, when a 1*µ*m laser beam passes through at a linear velocity of 10m/s, light is irradiated to a certain point on the optical disc for 100ns, and it is necessary to perform the aforementioned phase change and detect the reflectivity within such time frame.

Moreover, in order to realize the foregoing crystallographic phase change; that is, the phase change of the amorphous and crystal, not only will the recording layer be subject to heating and cooling more than once, the peripheral dielectric protective layer and aluminum alloy reflective film will also be repeatedly subject thereto.

In light of the above, a phase change optical disc has a four-layer structure wherein, for instance, both sides of a Ge-Sb-Te recording thin film layer are sandwiched with a zinc sulfide-silicon oxide (ZnS/SiO₂) high-melting point dielectric, and an aluminum alloy reflective layer is additionally provided thereto.

Among the above, in addition to being demanded of an optical function capable of increasing the reflective difference of the amorphous portion and crystal portion in recording layer, the reflective layer and protective layer are also demanded of a function for preventing the deformation caused by the moisture resistance or heat of the recording thin film as well as a function for controlling the thermal conditions upon recording (c.f. *"*Kogaku" magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and possess strength to prevent deterioration. From this perspective, the dielectric protective layer plays an important role.

The dielectric protective layer described above is usually formed with the sputtering method. This sputtering method makes a positive electrode target and a negative electrode target face each other, and generates an electric field by applying a high voltage between the substrates thereof and the targets under an inert gas atmosphere. The sputtering method employs a fundamental principle where plasma is formed with the collision of electrons, which are ionized at such time, and the inert gas, the positive ion in this plasma sputters the atoms structuring target by colliding with the target (negative electrode) surface, and the sputtered atoms adhere to the opposing substrate surface.

Conventionally, ZnS-SiO₂ is broadly used as the aforementioned protective layer of a rewritable optical information recording medium since it possesses superior characteristics such as optical characteristics, thermal characteristics, and adhesiveness with the recording layer. Sputtering has been used with a ceramic target such as ZnS-SiO₂ in order to form a thin film of approximately several hundred to several thousand Å

Nevertheless, since these materials have high target bulk resistance, it is not possible to perform deposition with a DC sputtering apparatus, and normally a radio frequency (RF) sputtering apparatus is used. In reality, not only is this radio frequency sputtering (RF) device an expensive device, it has numerous drawbacks in that the sputtering efficiency is inferior, power consumption is significant, control is difficult, and deposition speed is slow.

Moreover, when high power is applied to increase the deposition speed, there is a problem in that the substrate temperature will rise and cause a polycarbonate substrate to deform. Since the ZnS-SiO₂ is of a thick film thickness, there is also the problem of deteriorated throughput and increased costs.

A rewritable DVD is strongly demanded of, in addition to the shortening of the laser wavelength, increased write cycle, enlarged capacity and high-speed recording, and the foregoing ZnS-SiO₂ material faces other problems.

As one reason the write cycle of the optical information recording medium deteriorates, a gap is generated between the recording layer and protective layer during the repetition of heating and cooling of the recording layer material disposed so as to be sandwiched between ZnS-SiO₂. This causes the deterioration in characteristics such as the reflectance ratio and the like.

Although proposals have been made to provide an intermediate layer having nitride or carbide as its primary component between the recording layer and the protective layer in order to improve the adhesiveness between the layers, there is a problem in that the throughput will deteriorate and the costs will increase due to the addition of an extra layer.

In order to overcome the foregoing problem, a proposal has been made to increase the adhesiveness with the recording layer by securing a further stable amorphous nature in comparison to the protective layer ZnS-SiO₂.

Since a ZnO-based homologous compound (refer to Non-Patent Document 1) has a complicated layered structure, it is capable of retaining the amorphous nature more stably during deposition, is transparent in the used wavelength range, and has a refractive index that is similar to ZnS-SiO₂.

By adding ZnS to this ZnO-based homologous compound, it was expected that the amorphous nature could be improved, the sputtering characteristics could be stabilized by excluding the insulating material of SiO₂, and characteristics and productivity of the optical information recording medium could be improved.

As general examples of using a material having a homologous compound as its primary component as a transparent conductive material, for instance, there is a method of forming a zinc-indium oxide target via laser abrasion (refer to Patent Document 1), an example of a transparent conductive film containing amorphous oxide that has favorable conductivity and in particular blue light transparency (refer to Patent Document 2), and an example of a target for forming a moisture-resistant film having In and Zn as its primary components, is In₂O₃ (ZnO₂)m (m = 2 to 20), and the atomic ratio of In and Zn (In/(In + Zn)) is 0.2 to 0.85 (refer to Patent Document 3).

Nevertheless, the foregoing materials for forming a transparent conductive film were not necessary sufficient as a thin film (in particular for the use as a protective film) for an optical information recording medium.

Meanwhile, a compound target with ZnS added to a ZnO-based homologous compound encountered a problem in that it easily cracks during the manufacture of the target or during high power sputtering.
[Non-Patent Document 1] Technical Journal "Solid Physics" by Chunfei Lee et. al., Vol. 35, No. 1 , 2000, Pages 23 to 32, "Electron Microscope Observation of Modulated Structure of Homologous Compound RMO₃(ZnO)ₘ(R = In, Fe; M = In, Fe, Ga, Al; M = natural number)"
[Patent Document 1] Japanese Patent Laid-Open Publication No. 2000-26119
[Patent Document 2] Japanese Patent Laid-Open Publication No. 2000-44236
[Patent Document 3] Japanese Patent No. 2695605

### DISCLOSURE OF THE INVENTION

An object of the present invention is to provide a high-strength sputtering target capable of preventing cracks in a target upon manufacturing such a target or when forming a film via sputtering and a manufacturing method of such a sputtering target, as well as a thin film for an optical information recording medium optimal for use as a protective film and a manufacturing method of such a thin film.

In order to achieve the foregoing object, as a result of intense study, the present inventors discovered that by adopting a complex compound having zinc chalcogen such as ZnS and ZnO as its primary components, and controlling the rearrangement of the crystal phase of ZnS that occurs at a lower temperature than ordinary pure ZnS caused of the reaction of ZnS and oxide, it is possible to prevent cracks from occurring in a target and increase the density thereof, reduce the generation of particles and nodules during sputtering without impairing the characteristics as a protective film, and even improve the uniformity of the film thickness.

Based on the foregoing discovery, the present invention provides:
1) A sputtering target having zinc sulfide and indium oxide, zinc oxide and oxide composed of another trivalent positive element A as its primary components, wherein the ratio of sulfur in relation to the total components is 5 to 30wt%, the (111) peak strength I1 of cubic crystal ZnS and the (100) peak strength I2 of hexagonal ZnS measured by XRD coexist, and I1 > I2 is satisfied;
2) The sputtering target according to paragraph 1) above, wherein the average value of the half-value width of the (111) peak of the cubic crystal ZnS is 0.25 or less, and the standard deviation of the half-value width is 0.06 or less;
3) The sputtering target according to paragraph 1) or paragraph 2) above, wherein the trivalent positive element A is a material of one or more components selected from aluminum, gallium, yttrium, and lanthanum;
4) The sputtering target according to any one of paragraphs 1) to 3) above, wherein the average crystal grain size of a sulfide phase is greater than the average crystal grain size of an oxide phase, but is 10µm or less;
5) The sputtering target according to any one of paragraphs 1) to 4) above, wherein the relative density is 85% or higher, the average value of strength based on the 3-point bending strength (JIS R 1601) is 50MPa or higher, and the Weibull coefficient is 5 or higher; and
6) A thin film for an optical information recording medium formed using the sputtering target according to any one of paragraphs 1) to 5) above.

The present invention has zinc sulfide and indium oxide, zinc oxide and oxide composed of another trivalent positive element A as its primary components, and thereby seeks to stabilize the amorphous nature, improve the adhesiveness with the recording layer material of the optical information recording medium, and densify the relative density to 85% or higher so as to enable stable DC sputtering.

The present invention also yields a significant effect of enabling DC sputtering by adjusting the composition ratio, increasing the deposition speed and improving the sputtering efficiency. As a result, the present invention yields superior effects of being able reduce arcings during sputtering and the generation of particles (dust) and nodules during sputtering for deposition, having limited variation in quality and being able to improve the mass productivity, and being able to stably manufacture optical recording mediums having an optical disc protective film at low costs.

Since the average crystal grain size of the sulfide phase in the target is 10µm or less, zinc sulfide and indium oxide, zinc oxide and oxide composed of another trivalent positive element A are the primary components, and the present invention thereby possesses a texture where these components are evenly dispersed, stable sputtering and uniform deposition are enabled, and the present invention yields an effect of being able to form a thin film (protective film) for an optical information recording medium with superior characteristics.

### BEST MODE FOR CARRYING OUT THE INVENTION

The sputtering target of the present invention has zinc sulfide and indium oxide, zinc oxide and oxide composed of another trivalent positive element A as its primary components, wherein the ratio of sulfur in relation to the total components is 5 to 30wt%, the (111) peak strength I1 of cubic crystal ZnS and the (100) peak strength I2 of hexagonal ZnS measured by XRD coexist, and I1 > I2 is satisfied.

The reason zinc sulfide and indium oxide, zinc oxide and oxide composed of another trivalent positive element A are used as the primary components is in order to ensure amorphous stability. The reason the ratio of sulfur in relation to the total components is made to be 5 to 30wt% is also in order to ensure amorphous stability, and to obtain favorable optical characteristics and deposition speed.

The reason the (111) peak strength 11 of cubic crystal ZnS and the (100) peak strength 12 of hexagonal ZnS measured by XRD are made to coexist is in order to prevent cracks. As a result of the foregoing configuration, the present invention yields superior effects of being able to realize high-speed deposition and provide a target that will not crack easily.

With the component system of the present invention, the phase transition of ZnS will occur at a low temperature (roughly 700 to 900°C) which would not normally occur in single-phase ZnS or ZnS-SiO₂. Thus, when performing sintering and quenching near 1000°C in which the phase transition will not occur in conventional ZnS-SiO₂, the high temperature phase hexagonal system will be distributed unevenly in the target. It has been discovered that this uneven distribution is accumulated as residual strain in the target, whereby the target becomes vulnerable to cracking. When a low temperature phase and a high temperature phase coexist, it has been discovered that the average value of the half-value width in the XRD diffraction of the low temperature phase is desirably 0.25 or less, and the half-value width is desirably uniform in the target.

It is desirable that the average value of the half-value width of the (111) peak of the cubic crystal ZnS is 0.25 or less, and the standard deviation of the half-value width is 0.06 or less. Thereby, the crack prevention effect is increased even further.

As the trivalent positive element A, it is desirable to use a material of one or more components selected from aluminum, gallium, yttrium, and lanthanum.

With the sputtering target of the present invention, it is also desirable that the average crystal grain size of the sulfide phase is greater than the average crystal grain size of the oxide phase, but 10 *µ*m or less, and the relative density is 85% or higher. These are also effective for preventing cracks. Nevertheless, these are not requisite elements, but rather preferable conditions. Thus, it should be understood that the present invention can also be applied to numerical values outside the foregoing ranges.

By using the sputtering target of the present invention, significant effects are yielded in that the productivity will improve, it is possible to obtain a high quality material, and it is possible to stably and inexpensively manufacture an optical recording medium having an optical disc protective film.

The present invention is able to manufacture a high density sputtering target by performing pressureless sintering or high temperature pressure sintering to oxide powder of the respective constituent elements and chalcogen compound powder. It is desirable to perform sintering at a temperature of 1050°C or less. It will thereby be possible to adjust the crystal phase of ZnS to a desired value and prevent the generation of cracks. For cooling, it is desirable to retain the target at 500°C to 850°C or perform slow cooling.

It will thereby be possible to more effectively adjust the half-value width of ZnS (111) to a desired value. These adjustments differ significantly from conventional ZnS-SiO₂.

It is desirable to perform calcination at 800 to 1300°C after uniformly mixing the oxide powder having zinc oxide as its primary component before sintering, and it is further desirable to pulverize the oxide powder to 1 *µ*m or less after calcination. It is desirable to perform sintering in a vacuum or under an inert gas atmosphere such as argon or nitrogen atmosphere. It is also preferable to apply pressure using a hot press at a high temperature, and it is desirable to set the welding pressure in such a case to 150kgt/cm² or higher. It is thereby possible to obtain a sputtering target having a relative density of 85% or greater.

It is desirable that the oxide powder before sintering forms a compound with zinc oxide as its primary component. This is in order to increase the uniformity and more effectively exhibit the advantages of a homologous compound for further stabilizing the amorphous nature. Further, since the sulfate oxide (sulfate radical) contained in the zinc sulfide powder before sintering will cause the target to crack, it is preferable that this is reduced as much as possible.

By using the sputtering target of the present invention, significant effects are yielded in that the productivity will improve, it is possible to obtain a high quality material, and it is possible to stably and inexpensively manufacture an optical recording medium having an optical disc protective film.

Since the improvement in density of the sputtering target according to the present invention will reduce pores and refine the crystal grains, the sputtered surface of the target will be uniform and flat. Thus, the present invention yields a significant effect of being able to reduce the generation of particles and nodules during sputtering, prolong the target life, and improve the mass productivity with minimal variation in quality.

### [Examples]

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Examples 1 to 8)

ln₂O₃ powder equivalent to 4N and 5µm or less, Ga₂O₃ Al₂O₃ powder, Y₂O₃ powder, and La₂O₃ powder equivalent to 4N and 1µm or less, and ZnO powder equivalent to 4N and having an average grain size of 5µm or less were prepared, mixed at the molar ratio shown in Table 1 , subject to wet blending, dried, and then calcinated at 1100°C.

Subsequently, composite oxide powder and ZnS powder equivalent to 4N and having an average grain size of 5 *µ*m or less were mixed at the molar ratio shown in Table 1. The mixture was performed using a wet ball mill or a dry high speed mixer in order to disperse the respective powders evenly. The mixed powder was thereafter filled in a carbon mold and hot pressed at a temperature of 900°C to form a target. During the this process, the target was held for 2 hours or more at 700 to 800°C, and thereafter subject to slow cooling.

The (111) peak strength I1 of the cubic crystal ZnS and the (100) peak strength I2 of the hexagonal ZnS based on XRD measurement of this target coexisted, but the ratio thereof (XRD I1/I2) was within the range of 1.5 to 12 as shown in Table 1. Further, the average value of the half-value width of the (111) peak of the cubic crystal ZnS was 0.18 to 0.22, and the standard deviation of this half-value width was within the range of 0 to 0.03.

As a result of measuring the density (Archimedes method) by sampling from three arbitrarily locations in the target, the relative density was 85 to 97%, the average strength based on 3-point bending strength (JIS R 1601) was within the range of 55 to 80MPa, and the Weibull coefficient was within the range of 6 to 12.

The average crystal grain size of the ZnS phase in the target was 4*µ*m, and the average crystal grain size of the oxide phase was within the range of 0.8 to 1.5*µ*m. The foregoing numerical values were all within the target range of the present invention. In addition, no cracks in the target could be observed in any of the foregoing cases.

The foregoing 6-inch φ size target subject to finish processing was used to perform sputtering. The sputtering conditions were DC sputtering, sputtering power of 1000W, and Ar gas pressure of 0.5Pa, and deposition was performed at a target film thickness of 1500Å As shown in Table 1, the refractive index of the deposition sample was 2 to 2.2 (wavelength 633nm), and showed a favorable refractive index. The amorphous stability was within the range of 1.1 to 1.5, and also showed favorable results.

### (Comparative Examples 1 to 5)

In₂O₃ powder equivalent to 4N and 5µm or less, Ga₂O₃ Al₂O₃ powder and Y₂O₃ powder (not added in Comparative Example 4) equivalent to 4N and 1µm or less, and ZnO powder equivalent to 4N and having an average grain size of 5µm or less were prepared, mixed at the molar ratio shown in Table 1, subject to wet blending, dried, and then calcinated at 1100°C.

Subsequently, composite oxide powder and ZnS powder equivalent to 4N and having an average grain size of 5µm or less were mixed at the molar ratio shown in Table 1. The mixture was performed using a wet ball mill or a dry high speed mixer in order to disperse the respective powders evenly. The mixed powder was thereafter filled in a carbon mold and hot pressed at a temperature of 900 to 1100°C to form a target. The target was cooled without going through the process of holding the target for 2 hours or more at 700 to 800°C as with the Examples.

Although the (111) peak strength I1 of the cubic crystal ZnS and the (100) peak strength I2 of the hexagonal ZnS based on XRD measurement of this target coexisted, as shown in Table 1, the ratio thereof (XRD I1/I2) was 0.6 and 0.8 for Comparative Example 1 and Comparative Example 3, which are outside the scope of the present invention. Further, the average value of the half-value width of the (111) peak of the cubic crystal ZnS was 0.27 to 0.30, and the standard deviation of this half-value width was respectively 0.07 and 0.08, which are outside the scope of the present invention, for Comparative Example 1 and Comparative Example 2, in which the ZnS content is outside the scope of the present invention.

As a result of measuring the density (Archimedes method) by sampling from three arbitrarily locations in the target, the relative density was 75% for Comparative Example 5, and showed a significant deterioration in the density. The average strength based on 3-point bending strength (JIS R 1601) was 42MPa and 30MPa for Comparative Example 2 and Comparative Example 4, respectively, and the strength was low. The Weibull coefficient was low at 4 for both Comparative Example 2 and Comparative Example 5,

The average crystal grain size of the ZnS phase in the target was 12µm for Comparative Example 5, which was outside the scope of the present invention. The average crystal grain size of the oxide phase was 5µm for Comparative Example 2, which was outside the scope of the present invention. Cracks occurred during the manufacture in Comparative Example 1, cracks occurred during the sputtering in Comparative Examples 2, 3 and 5, and these Comparative Examples did not produce favorable targets.

The foregoing 6-inch φ size target subject to finish processing was used to perform sputtering. The sputtering conditions were DC sputtering, sputtering power of 1000W, and Ar gas pressure of 0.5Pa, and deposition was performed at a target film thickness of 1500Å As shown in Table 1, measurement was impossible in Comparative Example 1 because the target cracked during the manufacture. With the remaining deposition samples, the refractive index was 2.2 to 2.3 (wavelength 633nm) and showed a favorable refractive index. The amorphous stability deteriorated to 3.2 in Comparative Example 2 and 4.5 in Comparative Example 4, crystallization was observed in certain parts of the target, and the flatness of the film was lost.

**[Table 1]**

| | Composition mol% | S wt% | XRD l1/l2 | XRD l1 Ave. Half Value Width | Standard Deviation | Relative Density % | Ave. Strength MPa | Weibull Coefficient | ZnS Crystal Brain Size *µ*m | Oxide Phase Grain Size µm | Cracks | Retractive Index 633nm | Amorphous Stability |
|---|---|---|---|---|---|---|---|---|---|---|---|---|---|
| Example 1 | ZnS : In2O3 : Ga2O3 : ZnO = 64 : 6 ± 6 : 24 | 18.7 | 10 | 0.21 | 0 | 90 | 65 | 10 | 4 | 1.2 | None | 2.2 | 1.5 |
| Example 2 | ZnS : In2O3 : Ga2O3 : ZnO = 80 : 2 : 2 : 16 | 25.6 | 12 | 0.19 | 0.02 | 97 | 80 | 12 | 4 | 1 | None | 2.3 | 1.1 |
| Example 3 | ZnS : In2O3 : Ga2O3 : ZnO= 50 : 9 : 15 : 26 | 13.0 | 5 | 0.22 | 0.01 | 86 | 60 | 9 | 4 | 1 | None | 2.3 | 1.3 |
| Example 4 | ZnS : In2O3 : Al2O3 : ZnO = 25 : 10 : 5 : 60 | 7.5 | 1.5 | 0.22 | 0.03 | 85 | 55 | 6 | 4 | 0.8 | None | 2 | 1.3 |
| Example 6 | ZnS : In2O3 : Al2O3 : ZnO = 50 : 19 : 6 : 25 | 12.5 | 9 | 0.21 | 0.01 | 90 | 73 | 11 | 4 | 1.1 | None | 2.1 | 1.2 |
| Example 7 | ZnS : In2O3 : Y2O3 : ZnO = 65 ± 3 : 2 : 30 | 20.7 | 8 | 0.2 | 0.01 | 89 | 62 | 8 | 4 | 1.5 | None | 2.2 | 1.4 |
| Example 8 | ZnS: In2O3 : La2O3 : ZnO 70 : 7 : 3 ∓ 20 | 20.3 | 7 | 0.18 | 0.02 | 92 | 58 | 10 | 4 | 1.5 | None | 2.2 | 1.5 |
| | | | | | | | | | | | | | |
| Comparative Example 1 | ZnS : In2O3 : Al2O3 : ZnO = 15 : 15 : 10 ± 60 | 4.2 | 0.6 | 0.3 | 0.07 | 90 | 52 | 6 | 6 | 0.9 | Manufacture Cracks | - | - |
| Comparative Example 2 | ZnS : In2O3 ; Al2O3 ; ZnO = 94 : 1 ± 1 : 4 | 30.5 | 5 | 0.27 | 0.08 | 92 | 42 | 4 | 4 | 5 | Sputtering Cracks | 2.3 | 3.2 |
| Comparative Example 3 | ZnS: In2O3: Ga2O3: ZnO=65:7:7:21 | 18.4 | 0.8 | 0.24 | 0.05 | 96 | 65 | 10 | 8 | 1 | Sputtering Cracks | 2.2 | 1.1 |
| Comparative Example 4 | ZnS : In2O3: ZnO = 60 : 10 : 30 | 17.4 | 7 | 0.23 | 0.05 | 95 | 60 | 7 | 4 | 1.5 | None | 2.2 | 4.5 |
| Comparative Example 5 | ZnS : In2O3 : Y2O3 : ZnO =75 ± 3 : 7 :15 | 22.0 | 20 | 0.24 | 0.04 | 75 | 30 | 4 | 12 | 1.2 | Sputtering Cracks | 2.3 | 1.1 |

### INDUSTRIAL APPLICABILITY

The present invention has zinc sulfide and indium oxide, zinc oxide and oxide composed of another trivalent positive element A as its primary components, and thereby seeks to stabilize the amorphous nature, improve the adhesiveness with the recording layer material of the optical information recording medium, and densify the relative density to 85% or higher so as to enable stable DC sputtering.

The present invention also yields a significant effect of enabling DC sputtering by adjusting the composition ratio, facilitating the controllability of sputtering, increasing the deposition speed and improving the sputtering efficiency. As a result, the present invention yields superior effects of being able to reduce the generation of particles (dust) and nodules during sputtering for deposition, having limited variation in quality and being able to improve the mass productivity, and being able to stably manufacture optical recording mediums having an optical disc protective film at low costs.

Since the average crystal grain size of the sulfide phase in the target is 10µm or less, zinc sulfide and indium oxide, zinc oxide and oxide composed of another trivalent positive element A are the primary components, and the present invention thereby possesses a texture where these components are evenly dispersed, stable sputtering and uniform deposition are enabled, and the present invention yields an effect of being able to form a thin film (protective film) for an optical information recording medium with superior characteristics.

## Claims

1. A sputtering target having zinc sulfide and indium oxide, zinc oxide and oxide composed of another trivalent positive element A as its primary components, wherein the ratio of sulfur in relation to the total components is 5 to 30wt%, the (111) peak strength 11 of cubic crystal ZnS and the (100) peak strength 12 of hexagonal ZnS measured by XRD coexist, and I1 > I2 is satisfied.

2. The sputtering target according to claim 1, wherein the average value of the half-value width of the (111) peak of the cubic crystal ZnS is 0.25 or less, and the standard deviation of the half-value width is 0.06 or less.

3. The sputtering target according to claim 1 or claim 2, wherein the trivalent positive element A is a material of one or more components selected from aluminum, gallium, yttrium, and lanthanum.

4. The sputtering target according to any one of claims 1 to 3, wherein the average crystal grain size of a sulfide phase is greater than the average crystal grain size of an oxide phase, but is 10 µm or less.

5. The sputtering target according to any one of claims 1 to 4, wherein the relative density is 85% or higher, the average value of strength based on the 3-point bending strength (JIS R 1601) is 50MPa or higher, and the Weibull coefficient is 5 or higher.

6. A thin film for an optical information recording medium formed using the sputtering target according to any one of claims 1 to 5.
